# EUROPEAN PATENT APPLICATION

(11) **EP 4 633 039 A1**
(43) Date of publication of application: **15.10.2025**
(21) Application number: 23899207.7
(22) Date of filing: 08.02.2023
(51) Int. Cl.: H03H 9/17, H03H 9/13, H03H 9/02, H03H 3/02, H03H 3/04

(54) **ACOUSTIC RESONATOR AND MANUFACTURING METHOD THEREFOR**

(30) Priority: 07.12.2022 CN 202211566338
(71) Applicant: Spectron (Shenzhen) Technologies Co., Ltd, Shenzhen, Guangdong 518000 (CN)
(72) Inventor: GONG, Songbin, Shenzhen, Guangdong 518000 (CN); ALVAREZ, Gabriel Vidal, Shenzhen, Guangdong 518000 (CN); RAMOTTI, Martino, Shenzhen, Guangdong 518000 (CN)
(74) Representative: Schaafhausen, Anne
(86) International application number: PCT/CN2023/074924
(87) International publication number: WO 2024/119606

(57) **Abstract**

Provided are an acoustic resonator and a manufacturing method thereof, which relate to the technical field of piezoelectric resonators. The manufacturing method of the acoustic resonator includes: forming a bottom laminated structure on a side of a substrate; forming a bottom electrode layer, a piezoelectric layer, and a top electrode layer on a side of the bottom laminated structure facing away from the substrate; and forming a frequency-temperature coefficient compensation layer on a side of the bottom electrode layer, the piezoelectric layer, and the top electrode layer facing away from the substrate.

## Description

This application claims priority to Chinese Patent Application No. 202211566338.4 filed Dec. 7, 2022, the disclosure of which is incorporated herein by reference in its entirety.

### TECHNICAL FIELD

The present application relates to the technical field of piezoelectric resonators and, in particular, an acoustic resonator and a manufacturing method thereof.

### BACKGROUND

In high-end radio frequency front-end modules, acoustic devices are used for synthesizing devices with a low loss, a fast roll-off characteristic, and a filtering function. Such devices are microfabricated structures manufactured based on semiconductor technology and utilize acoustic vibration to synthesize a resonator equivalent to an inductor and a capacitor that are cascaded. These devices are commonly referred to as surface acoustic wave (SAW) devices or bulk acoustic wave (BAW) devices and can achieve an extremely high quality factor Q (directly related to the low loss) on the premise that they are compatible with modern electronic components and have extremely small dimensions. Thus, these devices have become a mainstream solution to radio frequency filtering in high-end front-end modules. In particular, to achieve a low loss at a high frequency above 2.5 GHz, the BAW devices have better performance that the SAW devices. Therefore, the BAW devices are more widely used in the high-frequency filtering technology of the high-end front-end modules.

In traditional BAW devices, a piezoelectric film layer is sandwiched between a metal electrode and other film layers to reduce the temperature sensitivity of the devices. There are mainly two types of BAW device in structure. One type of BAW device is based on a suspended thin film, and the other type of BAW device is based on a thin film fixed on a substrate with a laminated of reflective layers. In both cases, the resonant frequency of an acoustic device is set by the thickness of a piezoelectric layer and the total thickness of other thin films in contact with the piezoelectric layer. New 5G standards require operation at a higher frequency (above 3 GHz) and on a larger bandwidth. The requirement for a high frequency poses a new challenge to the BAW devices. The BAW devices need to utilize extremely thin films, which poses a great challenge to the manufacturing of resonators, limits the mass production yield of the resonators, and increases a cost.

### SUMMARY

Embodiments of the present application provide an acoustic resonator and a manufacturing method thereof so that the acoustic resonator operates at a high frequency and on a wide bandwidth, has a low loss, low temperature sensitivity, and a small size, and is easy to manufacture.

In a first aspect, the embodiments of the present application provide a manufacturing method of an acoustic resonator. The method includes the steps described below.

A bottom laminated structure is formed on a side of a substrate.

A bottom electrode layer, a piezoelectric layer, and a top electrode layer are formed on a side of the bottom laminated structure facing away from the substrate.

A frequency-temperature coefficient compensation layer is formed on a side of the bottom electrode layer, the piezoelectric layer, and the top electrode layer facing away from the substrate.

In a second aspect, the embodiments of the present application provide an acoustic resonator. The acoustic resonator includes a substrate, a bottom laminated structure, a bottom electrode layer, a piezoelectric layer, a top electrode layer, and a frequency-temperature coefficient compensation layer.

The bottom laminated structure is located on a side of the substrate.

The bottom electrode layer, the piezoelectric layer, and the top electrode layer are located on a side of the bottom laminated structure facing away from the substrate.

The frequency-temperature coefficient compensation layer is located on a side of the bottom electrode layer, the piezoelectric layer, and the top electrode layer facing away from the substrate.

### BRIEF DESCRIPTION OF DRAWINGS

FIG. 1 is a flowchart of a manufacturing method of an acoustic resonator according to an embodiment of the present application.
FIGS. 2 to 13 are diagrams of a manufacturing process of an acoustic resonator according to an embodiment of the present application.
FIG. 14 is another flowchart of a manufacturing method of an acoustic resonator according to an embodiment of the present application.
FIG. 15 is a top view of an acoustic resonator according to an embodiment of the present application.
FIG. 16 is a sectional view of FIG. 15. taken along AA'.

### DETAILED DESCRIPTION

The present application is further described hereinafter in detail in conjunction with drawings and embodiments. It is to be understood that the embodiments described herein are intended to explain the present application and not to limit the present application. Additionally, it is to be noted that for ease of description, only part, not all, of the structures related to the present application are illustrated in the drawings.

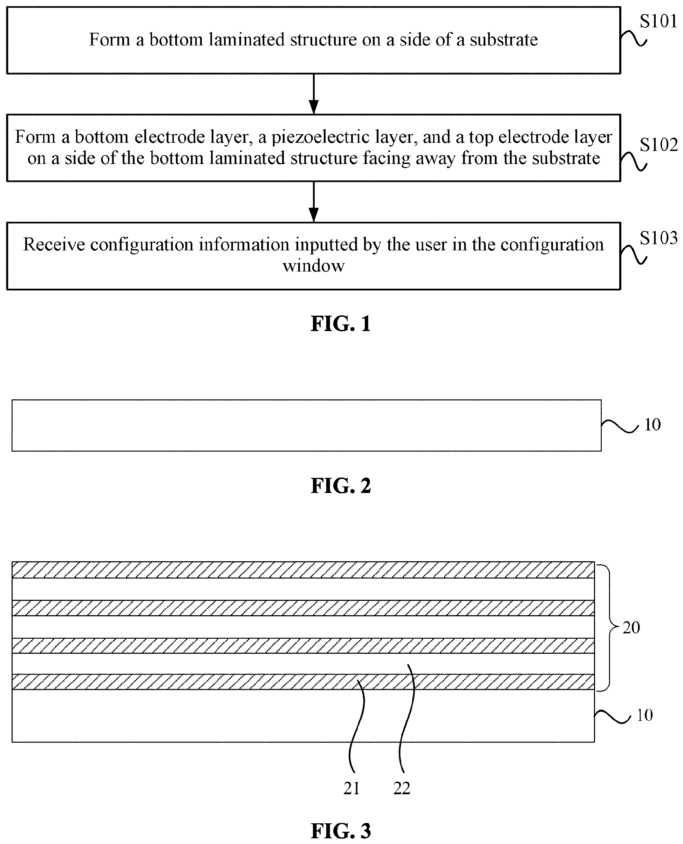

FIG. 1 is a flowchart of a manufacturing method of an acoustic resonator according to an embodiment of the present application. FIGS. 2 to 13 are diagrams of a manufacturing process of an acoustic resonator according to an embodiment of the present application. Referring to FIG. 1 and FIGS. 2 to 13, the manufacturing method of the acoustic resonator includes the steps described below.

In S101, a bottom laminated structure is formed on a side of a substrate.

A material of the substrate 10 is not limited in the embodiment of the present application.

For example, when a film in the bottom laminated structure 20 and closest to the substrate 10 has a low acoustic impedance, a substrate 10 with a high acoustic impedance may be selected. When the film in the bottom laminated structure 20 and closest to the substrate 10 has a high acoustic impedance, a substrate 10 with a low acoustic impedance may be selected.

For example, the material of the substrate 10 includes silicon, that is, a silicon wafer is used as the substrate 10.

In S102, a bottom electrode layer, a piezoelectric layer, and a top electrode layer are formed on a side of the bottom laminated structure facing away from the substrate.

The bottom electrode layer 31, the piezoelectric layer 32, and the top electrode layer 33 may be sequentially formed. Thus, the piezoelectric layer 32 is located between the bottom electrode layer 31 and the top electrode layer 33. For example, forming the bottom electrode layer 31, the piezoelectric layer 32, and the top electrode layer 33 on a side of the bottom laminated structure 20 facing away from the substrate 10 includes: forming the bottom electrode layer 31 on the side of the bottom laminated structure 20 facing away from the substrate 10; forming the piezoelectric layer 32 on the side of the bottom electrode layer 31 facing away from the substrate 10; and forming the top electrode layer 33 on the side of the piezoelectric layer 32 facing away from the substrate 10.

For example, the bottom electrode layer 31 may include Mo (molybdenum). In the process of forming the bottom electrode layer 31, a metal film of Mo may be formed in a deposition manner and then patterned so as to obtain the bottom electrode layer 31.

For example, a piezoelectric film of Al₁₋ₓScₓN is deposited so that the piezoelectric layer 32 is made.

For example, the top electrode layer 33 includes aluminum. In the process of forming the top electrode layer 33, a metal film of aluminum may be formed in the deposition manner and then patterned so as to obtain the top electrode layer 33.

In S103, a frequency-temperature coefficient compensation layer is formed on a side of the bottom electrode layer, the piezoelectric layer, and the top electrode layer facing away from the substrate.

For example, the frequency-temperature coefficient compensation layer 40 includes SiO₂ (silicon dioxide). In the process of forming the frequency-temperature coefficient compensation layer 40, a film of SiO₂ may be formed in the deposition manner and then patterned so as to obtain the frequency-temperature coefficient compensation layer 40.

For example, the frequency-temperature coefficient compensation layer 40 and the piezoelectric layer 32 have opposite temperature coefficients.

For example, the acoustic resonator also includes a top laminated structure located on the side of the bottom laminated structure facing away from the substrate. The top laminated structure includes the bottom electrode layer 31, the piezoelectric layer 32, the top electrode layer 33, and the frequency-temperature coefficient compensation layer 40.

The embodiment of the present application provides the manufacturing method of the acoustic resonator, where the bottom laminated structure is formed on the side of the substrate, the bottom electrode layer, the piezoelectric layer, and the top electrode layer are formed on the side of the bottom laminated structure facing away from the substrate, and the frequency-temperature coefficient compensation layer is formed on the side of the bottom electrode layer, the piezoelectric layer, and the top electrode layer facing away from the substrate. It is ensured that most resonance of a resonant cavity is formed in the frequency-temperature coefficient compensation layer so that low sensitivity to temperature is achieved. Therefore, a laminate of the acoustic resonator can be formed with relatively thick layers to produce a given resonance frequency, simplifying a manufacturing process, and the resonance frequency can be adjusted by etching and/or trimming the topmost layer of the acoustic resonator. In this manner, the acoustic resonator operates at a high frequency and on a wide bandwidth, has a low loss, low temperature sensitivity, and a small size, and is easy to manufacture.

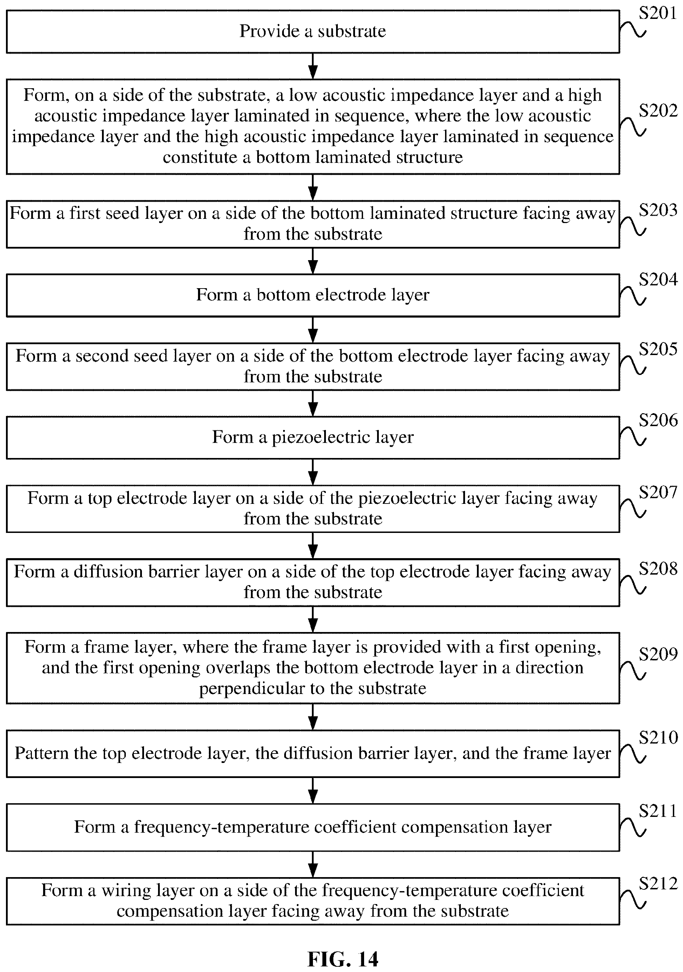

FIG. 14 is another flowchart of a manufacturing method of an acoustic resonator according to an embodiment of the present application. Referring to FIG. 14 and FIGS. 2 to 13, the manufacturing method of the acoustic resonator includes the steps described below.

In S201, a substrate is provided.

Referring to FIG. 2, the substrate 10 is provided.

For example, the substrate 10 serves as a connecting body between the acoustic resonator and an encapsulating polymer for mounting the acoustic resonator. The encapsulating polymer serves as a material of the acoustic resonator for absorbing sound energy outside a passband.

In S202, a low acoustic impedance layer and a high acoustic impedance layer laminated in sequence are formed on a side of the substrate, where the low acoustic impedance layer and the high acoustic impedance layer laminated in sequence constitute a bottom laminated structure.

Referring to FIG. 3, the low acoustic impedance layer 21 and the high acoustic impedance layer 22 laminated in sequence are formed on the side of the substrate 10. The low acoustic impedance layer 21 and the high acoustic impedance layer 22 are spaced from each other. One high acoustic impedance layer 22 is interposed between two adjacent low acoustic impedance layers 21. One low acoustic impedance layer 21 is interposed between two adjacent high acoustic impedance layers 22. The acoustic impedance of the high acoustic impedance layer 22 is higher than the acoustic impedance of the low acoustic impedance layer 21. The number of laminates of the high acoustic impedance layers 22 and the low acoustic impedance layers 21 is not limited in the embodiment of the present application.

For example, referring to FIG. 3, a film in the bottom laminated structure 20 and closest to the substrate 10 is the low acoustic impedance layer 21. The low acoustic impedance layer 21 is in contact with the substrate 10.

For example, referring to FIG. 3, a film in the bottom laminated structure 20 and farthest from the substrate 10 is also the low acoustic impedance layer 21.

For example, referring to FIG. 3, the bottom laminated structure 20 serves as a Bragg reflector for the acoustic resonator.

For example, the low acoustic impedance layer 21 and the high acoustic impedance layer 22 are made of SiO₂ (silicon dioxide) and AlN (aluminum nitride) respectively.

In S203, a first seed layer is formed on a side of the bottom laminated structure facing away from the substrate.

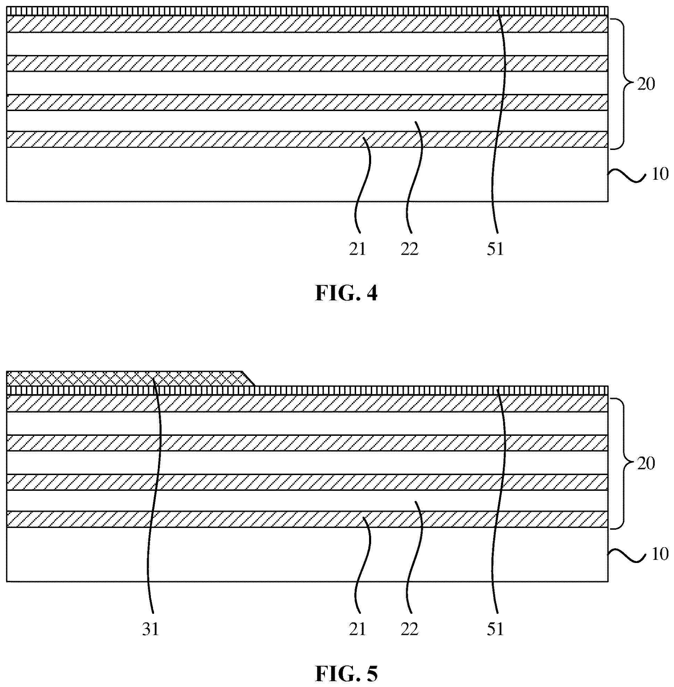

Referring to FIG. 4, the first seed layer 51 is formed on the side of the bottom laminated structure 20 facing away from the substrate 10. Specifically, the first seed layer 51 is formed on a side of the low acoustic impedance layer 21 facing away from the substrate 10. The first seed layer 51 is in contact with the low acoustic impedance layer 21.

In other embodiments, the first seed layer 51 may be formed on a side of the high acoustic impedance layer 22 facing away from the substrate 10.

In S204, a bottom electrode layer is formed.

Referring to FIG. 5, the bottom electrode layer 31 is formed on a side of the first seed layer 51 facing away from the substrate 10.

In S205, a second seed layer is formed on a side of the bottom electrode layer facing away from the substrate.

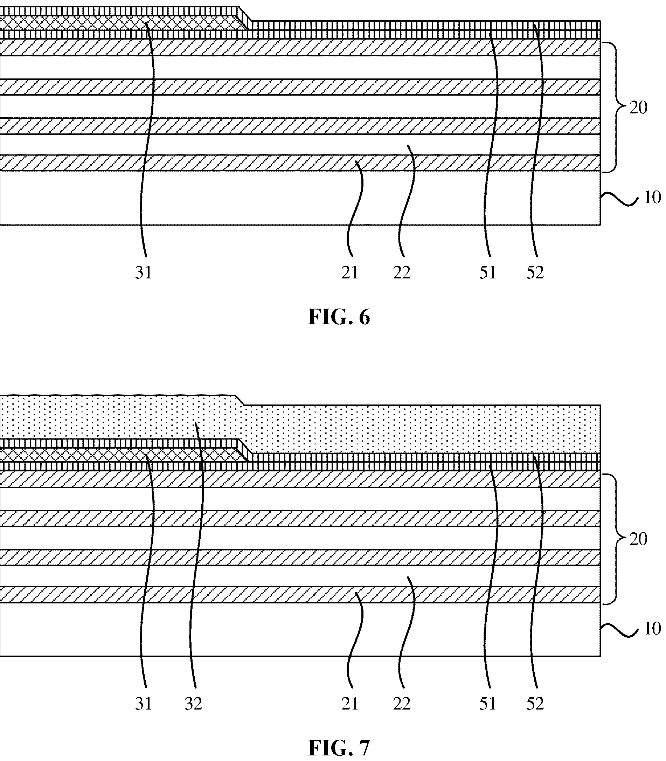

Referring to FIG. 6, the second seed layer 52 is formed on the side of the bottom electrode layer 31 facing away from the substrate 10. The second seed layer 52 and the first seed layer 51 enclose the bottom electrode layer 31. On the other hand, the second seed layer 52 formed on the bottom electrode layer 31 may serve as a growth substrate for a subsequent film to facilitate growth of the subsequent film. For example, growth of a subsequent piezoelectric layer 32 may be facilitated.

For example, materials of the first seed layer 51 and the second seed layer 52 are both AlN (aluminum nitride).

In S206, the piezoelectric layer 32 is formed.

Referring to FIG. 7, the piezoelectric layer 32 is formed on a side of the second seed layer 52 facing away from the substrate 10. The piezoelectric layer 32 serves as a transducer layer for the acoustic resonator.

In S207, a top electrode layer is formed on a side of the piezoelectric layer facing away from the substrate.

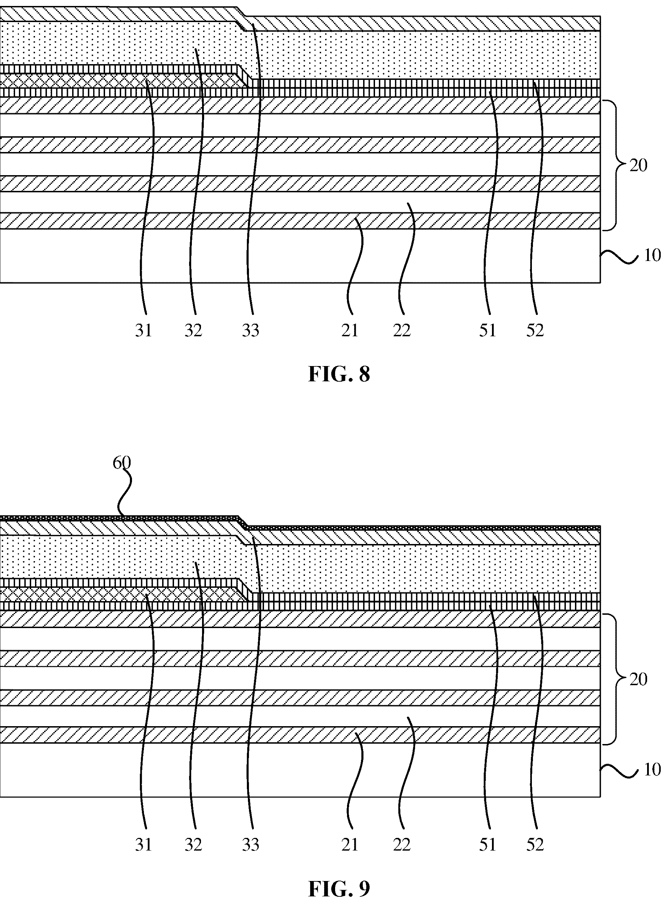

Referring to FIG. 8, the top electrode layer 33 is formed on the side of the piezoelectric layer 32 facing away from the substrate 10. A variable electric field formed by the top electrode layer 33 and the bottom electrode layer 31 can excite a mechanical vibration of the piezoelectric layer 32, thereby forming an acoustic vibration in the piezoelectric layer 32.

For example, the top electrode layer 33 includes Al (aluminum).

In S208, a diffusion barrier layer is formed on a side of the top electrode layer facing away from the substrate.

Referring to FIG. 9, the diffusion barrier layer 60 is formed on the side of the top electrode layer 33 facing away from the substrate 10.

In this step, the diffusion barrier layer 60 entirely covers the top electrode layer 33.

For example, a material of the diffusion barrier layer 60 includes Ti (titanium).

In S209, a frame layer is formed, where the frame layer is provided with a first opening, and the first opening overlaps the bottom electrode layer in a direction perpendicular to the substrate.

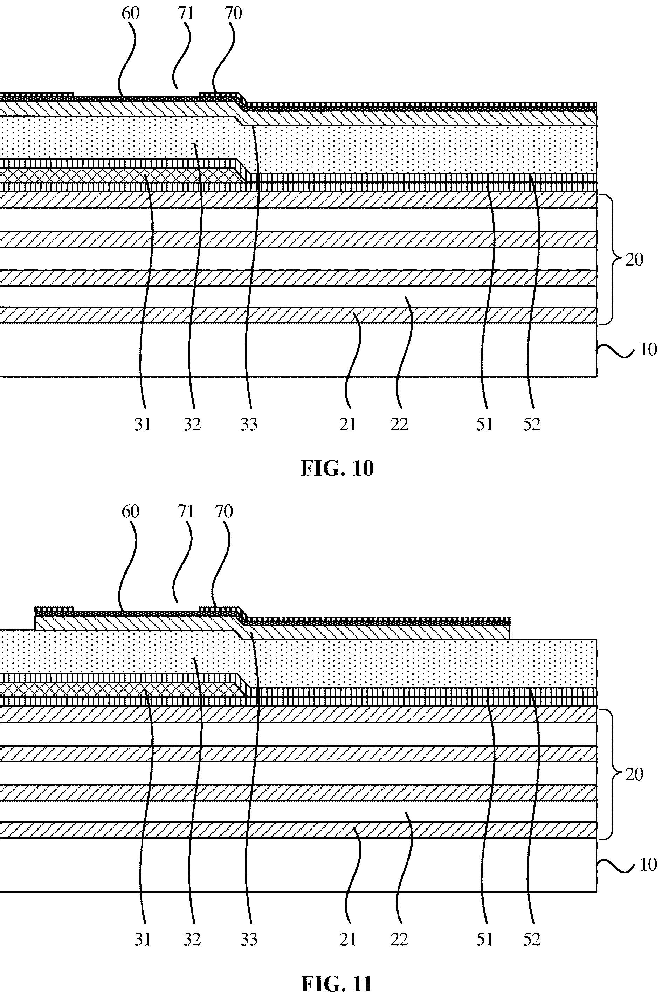

Referring to FIG. 10, the frame layer 70 is formed on a side of the diffusion barrier layer 60 facing away from the substrate 10. The frame layer 70 is provided with the first opening 71, and the first opening 71 overlaps the bottom electrode layer 31 in the direction perpendicular to the substrate 10.

For example, the frame layer 70 can suppress stray-induced spurious modes. Any film (metal or dielectric) layer may be added or the top electrode layer 33 may be partially removed so that the frame layer 70 is made.

For example, the frame layer 70 includes Ti (titanium).

For example, before the frequency-temperature coefficient compensation layer 40 is formed on the side of the bottom electrode layer 31, the piezoelectric layer 32, and the top electrode layer 33 that faces away from the substrate 10, a frame layer 70 is further formed on the same side of the bottom electrode layer 31, the piezoelectric layer 32, and the top electrode layer 33 that faces away from the substrate 10. The frame layer 70 is provided with the first opening 71, and in a direction perpendicular to the substrate 10, the projections of the first opening 71 and the bottom electrode layer 31 onto the plane of the substrate 10 overlap.

In S210, the top electrode layer, the diffusion barrier layer, and the frame layer are patterned.

Referring to FIG. 11, the top electrode layer 33, the diffusion barrier layer 60, and the frame layer 70 are patterned. The edge of the patterned top electrode layer 33, the edge of the patterned diffusion barrier layer 60, and the edge of the patterned frame layer 70 are aligned.

In other embodiments, at least two of the edge of the patterned top electrode layer 33, the edge of the patterned diffusion barrier layer 60, and the edge of the patterned frame layer 70 are misaligned.

In S211, a frequency-temperature coefficient compensation layer is formed.

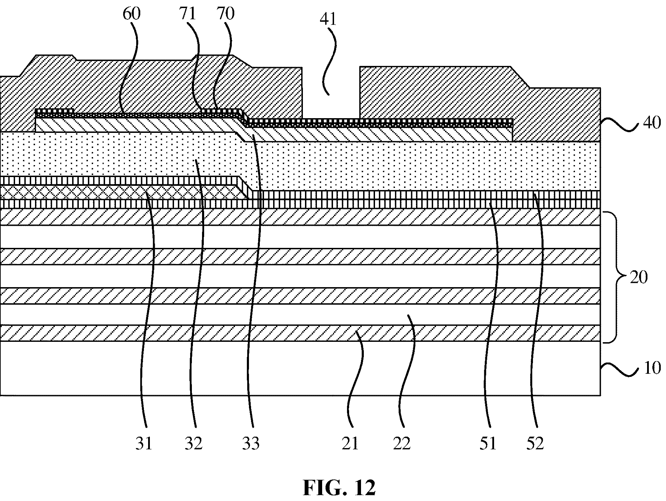

Referring to FIG. 12, the frequency-temperature coefficient compensation layer 40 is formed on a side of the frame layer 70 facing away from the substrate 10. The frequency-temperature coefficient compensation layer 40 is formed with a second opening 41. The second opening 41 is staggered from the first opening 71 in the direction perpendicular to the substrate 10, that is, the projections of the second opening 41 and the first opening 71 onto the plane of the substrate 10 do not overlap. The projections of the second opening 41 and the top electrode layer 33 onto the plane of the substrate 10 overlap in the direction perpendicular to the substrate 10.

In S212, a wiring layer is formed on a side of the frequency-temperature coefficient compensation layer facing away from the substrate.

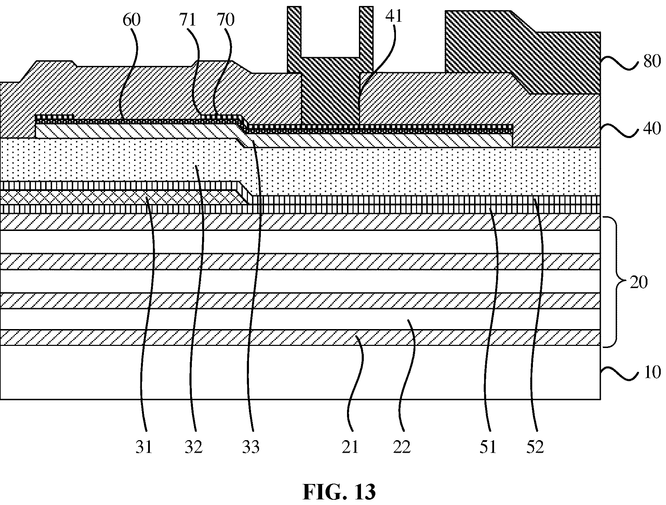

Referring to FIG. 13, the wiring layer 80 is formed on the side of the frequency-temperature coefficient compensation layer 40 facing away from the substrate 10. The wiring layer 80 fills the second opening 41 and is electrically connected to the frame layer 70 by being in contact so that the wiring layer 80 is electrically connected to the top electrode layer 33 through the frame layer 70 and the diffusion barrier layer 60.

For example, the wiring layer 80 is used for connecting the acoustic resonator to other components, such as other resonators and/or electrical interface components.

For example, the wiring layer 80 may include Al (aluminum). In the process of forming the wiring layer 80, a metal film of Al may be formed in a deposition manner and then patterned so as to obtain the wiring layer 80.

The above is one embodiment of the present application and is not intended to limit the present application. The preceding one or more steps may be omitted, or the order of the preceding one or more steps may be adjusted.

In an embodiment, at least one of step S203 or step S205 may be omitted. That is, either the step of forming the first seed layer 51 or the step of forming the second seed layer 52 is omitted or neither the first seed layer nor the second seed layer is formed.

In an embodiment, at least one of step S208 or step S209 may be omitted. That is, either the step of forming the diffusion barrier layer 60 or the step of forming the frame layer 70 is omitted or neither the diffusion barrier layer 60 nor the frame layer 70 is formed. In this case, in the step of patterning the top electrode layer 33, the patterning of the omitted film is also omitted. For example, the steps of forming the diffusion barrier layer 60 and the frame layer 70 are omitted. Then, step S210 is correspondingly changed to that the top electrode layer 33 is patterned.

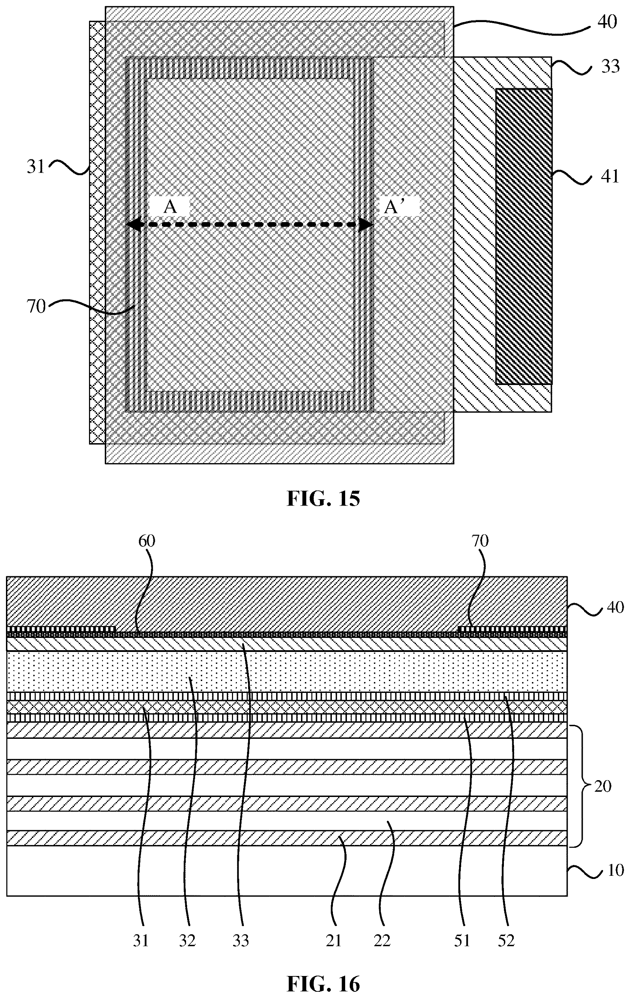

FIG. 15 is a top view of an acoustic resonator according to an embodiment of the present application. FIG. 16 is a sectional view of FIG. 15 taken along AA'. Referring to FIGS. 13, 15, and 16, the acoustic resonator includes a substrate 10, a bottom laminated structure 20, a bottom electrode layer 31, a piezoelectric layer 32, a top electrode layer 33, and a frequency-temperature coefficient compensation layer 40. The bottom laminated structure 20 is located on a side of the substrate 10. The bottom electrode layer 31, the piezoelectric layer 32, and the top electrode layer 33 are located on a side of the bottom laminated structure 20 facing away from the substrate 10. The frequency-temperature coefficient compensation layer 40 is located on a side of the bottom electrode layer 31, the piezoelectric layer 32, and the top electrode layer 33 facing away from the substrate 10.

The embodiment of the present application provides the acoustic resonator that achieves low temperature sensitivity by ensuring that most resonance of a resonant cavity is formed in the frequency-temperature coefficient compensation layer. Therefore, a laminate of the acoustic resonator can be formed with relatively thick layers to produce a given resonance frequency, simplifying a manufacturing process, and the resonance frequency can be adjusted by etching and/or trimming the topmost layer of the acoustic resonator. In this manner, the acoustic resonator operates at a high frequency and on a wide bandwidth, has a low loss, low temperature sensitivity, and a small size, and is easy to manufacture.

Optionally, the bottom electrode layer 31 is located between the substrate 10 and the piezoelectric layer 32, the piezoelectric layer 32 is located between the bottom electrode layer 31 and the top electrode layer 33, and the top electrode layer 33 is located between the piezoelectric layer 32 and the frequency-temperature coefficient compensation layer 40. The acoustic resonator also includes a first seed layer 51 and a second seed layer 52. The first seed layer 51 is located between the bottom laminated structure 20 and the bottom electrode layer 31. The second seed layer 52 is located between the bottom electrode layer 31 and the piezoelectric layer 32.

For example, the bottom laminated structure 20 serves as a Bragg reflector for the acoustic resonator. The bottom laminated structure 20 includes a low acoustic impedance layer 21 and a high acoustic impedance layer 22 laminated in sequence.

For example, the acoustic resonator also includes a diffusion barrier layer 60 between the top electrode layer 33 and the frequency-temperature coefficient compensation layer 40.

For example, the acoustic resonator also includes a frame layer 70 between the diffusion barrier layer 60 and the frequency-temperature coefficient compensation layer 40. The frame layer 70 is provided with a first opening 71, and the projections of the first opening 71 and the bottom electrode layer 31 onto the plane of the substrate 10 overlap in a direction perpendicular to the substrate 10.

For example, the acoustic resonator also includes a wiring layer 80. The frequency-temperature coefficient compensation layer 40 is provided with a second opening 41, and the second opening 41 is staggered from the first opening 71 in the direction perpendicular to the substrate 10, that is, the projections of the second opening 41 and the first opening 71 onto the plane of the substrate 10 do not overlap. The projections of the second opening 41 and the top electrode layer 33 onto the plane of the substrate 10 overlap in the direction perpendicular to the substrate 10. The wiring layer 80 fills the second opening 41 and is electrically connected to the frame layer 70 by being in contact so that the wiring layer 80 is electrically connected to the top electrode layer 33 through the frame layer 70 and the diffusion barrier layer 60.

Further, for a laminated structure, the acoustic resonator includes the bottom laminated structure 20 and a top laminated structure. The top laminated structure is located on the side of the bottom laminated structure 20 facing away from the substrate 10. The top laminated structure includes the bottom electrode layer 31, the piezoelectric layer 32, the top electrode layer 33, and the frequency-temperature coefficient compensation layer 40.

A phase length refers to a phase shift of a sound wave when the sound wave propagates through a medium with a certain thickness. The magnitude of the phase length is the ratio of the absolute thickness of the medium to the phase velocity of the sound wave. Therefore, the magnitude of the phase length can intuitively represent the thickness of the medium.

In an embodiment, the thickness of the top laminated structure is the total length of the bottom electrode layer 31, the piezoelectric layer 32, the top electrode layer 33, and the frequency-temperature coefficient compensation layer 40 in the direction perpendicular to the substrate 10. The overall phase length of the top laminated structure should be greater than half a period (that is, greater than π) so as to ensure that the acoustic resonator can operate at higher-order harmonics of the most fundamental mode.

The frequency-temperature coefficient compensation layer 40 needs to have acoustic impedance similar to an acoustic impedance of the piezoelectric layer 32. so that a very large part of standing wave patterns formed in the top laminated structure of the acoustic resonator are confined in the frequency-temperature coefficient compensation layer 40. This has two advantages: the frequency sensitivity of the acoustic resonator to a temperature change is reduced and the frequency sensitivity of the acoustic resonator to the trimming of the topmost layer is increased.

Further, the thickness of the top laminated structure needs to be selected to achieve maximum coupling. This requirement further limits the overall phase length of the top laminated structure to a multiple of half a period (that is, nπ, where n = 2, 3, 4, ...).

In an embodiment, the acoustic thickness of each layer of alternate layers formed by the low acoustic impedance layer 21 and the high acoustic impedance layer 22 may be designed to be an odd multiple of a quarter of the period of an excited vibration mode, that is, (2n + 1) π/2, where n = 0, 1, 2, ... In other embodiments, the acoustic thickness of each low acoustic impedance layer 21 and the acoustic thickness of each high acoustic impedance layer 22 may be designed to be other values in combination with actual use scenarios and user needs.

## Claims

1. A manufacturing method of an acoustic resonator, comprising:
forming a bottom laminated structure on a side of a substrate;
forming a bottom electrode layer, a piezoelectric layer, and a top electrode layer on a side of the bottom laminated structure facing away from the substrate; and
forming a frequency-temperature coefficient compensation layer on a side of the bottom electrode layer, the piezoelectric layer, and the top electrode layer facing away from the substrate.

2. The manufacturing method according to claim 1, wherein forming the bottom laminated structure on the side of the substrate comprises:
forming, on the side of the substrate, a low acoustic impedance layer and a high acoustic impedance layer laminated in sequence, wherein the low acoustic impedance layer and the high acoustic impedance layer laminated in sequence constitute the bottom laminated structure.

3. The manufacturing method according to claim 1, wherein forming the bottom electrode layer, the piezoelectric layer, and the top electrode layer on the side of the bottom laminated structure facing away from the substrate comprises:
forming the bottom electrode layer on the side of the bottom laminated structure facing away from the substrate;
forming the piezoelectric layer on a side of the bottom electrode layer facing away from the substrate; and
forming the top electrode layer on a side of the piezoelectric layer facing away from the substrate.

4. The manufacturing method according to claim 3, wherein before forming the bottom electrode layer on the side of the bottom laminated structure facing away from the substrate, the method further comprises:
forming a first seed layer on the side of the bottom laminated structure facing away from the substrate;
wherein before forming the piezoelectric layer on the side of the bottom electrode layer facing away from the substrate, the method further comprises:
forming a second seed layer on the side of the bottom electrode layer facing away from the substrate.

5. The manufacturing method according to claim 1, wherein before forming the frequency-temperature coefficient compensation layer on the side of the bottom electrode layer, the piezoelectric layer, and the top electrode layer facing away from the substrate, the method further comprises:
forming a diffusion barrier layer on the side of the bottom electrode layer, the piezoelectric layer, and the top electrode layer facing away from the substrate.

6. The manufacturing method according to claim 1, wherein before forming the frequency-temperature coefficient compensation layer on the side of the bottom electrode layer, the piezoelectric layer, and the top electrode layer facing away from the substrate, the method further comprises:
forming a frame layer on the side of the bottom electrode layer, the piezoelectric layer, and the top electrode layer facing away from the substrate;
wherein the frame layer is provided with a first opening, and the projections of the first opening and the bottom electrode layer overlap on the plane of the substrate in a direction perpendicular to the substrate.

7. The manufacturing method according to claim 1, wherein before forming the frequency-temperature coefficient compensation layer on the side of the bottom electrode layer, the piezoelectric layer, and the top electrode layer facing away from the substrate, the method further comprises:
patterning the top electrode layer.

8. The manufacturing method according to claim 1, wherein after forming the frequency-temperature coefficient compensation layer on the side of the bottom electrode layer, the piezoelectric layer, and the top electrode layer facing away from the substrate, the method further comprises:
forming a wiring layer on a side of the frequency-temperature coefficient compensation layer facing away from the substrate.

9. An acoustic resonator, comprising:
a substrate;
a bottom laminated structure located on a side of the substrate;
a bottom electrode layer, a piezoelectric layer, and a top electrode layer located on a side of the bottom laminated structure facing away from the substrate; and
a frequency-temperature coefficient compensation layer located on a side of the bottom electrode layer, the piezoelectric layer, and the top electrode layer facing away from the substrate.

10. The acoustic resonator according to claim 9, wherein the bottom electrode layer is located between the substrate and the piezoelectric layer, the piezoelectric layer is located between the bottom electrode layer and the top electrode layer, and the top electrode layer is located between the piezoelectric layer and the frequency-temperature coefficient compensation layer; and
wherein the acoustic resonator further comprises:
a first seed layer located between the bottom laminated structure and the bottom electrode layer; and
a second seed layer located between the bottom electrode layer and the piezoelectric layer.
